# DEMANDE DE BREVET EUROPEEN

(11) **EP 2 312 748 A1**
(43) Date de publication de la demande: **20.04.2011**
(21) Numéro de dépôt: 09405182.8
(22) Date de dépôt: 19.10.2009
(51) Int. Cl.: H03F 3/08

(54) **Système de détection de signaux haute fréquence à bande étroite**

(71) Demandeur: CSEM Centre Suisse d'Electronique et de Microtechnique SA, 2002 Neuchâtel (CH)
(72) Inventeur: Lecomte, Steve, 1233 Bernex (CH); Haesler, Jacques, 3280 Morat (CH)
(74) Mandataire: Savoye, Jean-Paul

(57) **Abrégé**

Un système permettant de détecter un signal au contenu spectral très réduit, dont la fréquence fondamentale est de l'ordre de quelques gigahertz, est présenté. Le système comprend un photodétecteur, un circuit de résonance parallèle et un amplificateur de configuration simple. Le système de détection est capable de détecter des signaux de très bas niveau et fonctionne avec une faible consommation de courant.

## Description

### DOMAINE TECHNIQUE

La présente invention concerne le domaine des amplificateurs à faible bruit pour amplifier des signaux aux fréquences RF ou micro-ondes. L'invention concerne en particulier des détecteurs optoélectroniques haute fréquence et peut être avantageusement employé dans des applications nécessitant une faible consommation d'énergie.

### TECHNIQUE ANTERIEURE

Il existe des amplificateurs haute fréquence à faible bruit, en particulier des amplificateurs RF, qui sont utilisés notamment dans les domaines de la réception de signaux radio ou de la téléphonie, pour détecter un signal venant d'une antenne ou d'une connexion par câble coaxial. De tels amplificateurs doivent amplifier des signaux dans une bande de fréquences bien définie tout en rejetant toute autre fréquence qui n'est pas comprise dans la bande de fréquences définie. L'étage d'entrée est souvent adapté pour correspondre à l'impédance de l'antenne ou du câble coaxial, soit 50 ohms en général, afin de maximiser le transfert de puissance par l'amplificateur. Dans le domaine de la téléphonie en particulier, l'amplificateur peut être adapté pour travailler dans plus qu'une bande de fréquences. Dans ces domaines, les signaux traités ont typiquement une fréquence de centre et une bande de fréquences autour de cette fréquence de centre - on appelle ceci la bande passante.

Un amplificateur est connu de la publication du brevet américain numéro US4975658. Cet amplificateur à haute fréquence est adapté pour recevoir des signaux par une antenne. Cet amplificateur comprend un circuit de résonance à l'entrée pour réaliser un filtre passe-bande.

Un autre amplificateur à faible bruit pour amplifier des signaux radio ou micro-ondes est connu de la publication de brevet américain numéro US5406226. Le circuit comprend des adaptations d'impédance à l'entrée et à la sortie pour 50 ohms et travaille à une fréquence de 900MHz.

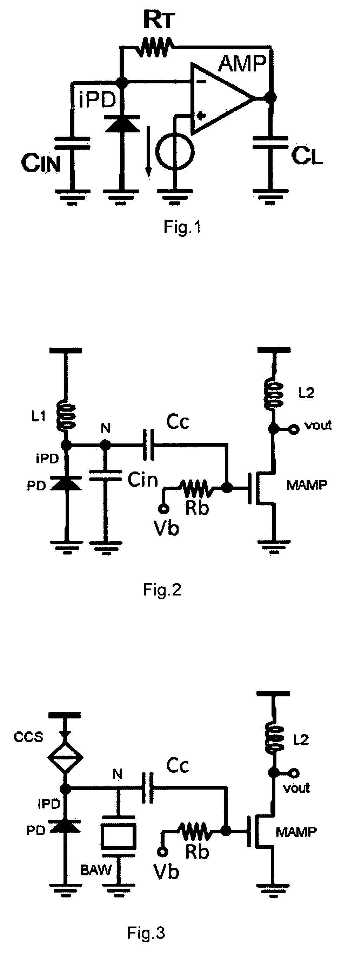

La Fig 1 montre un système qui est souvent utilisé dans le domaine de détection optoélectronique de signaux à haute fréquence. Ce système est basé sur un amplificateur de transimpédance (AMP). La photodiode (PD) génère un courant (i_{PD}). Pour que celui-ci passe par l'amplificateur (AMP), et ensuite à travers la résistance de contre-réaction (RT), il faut que l'impédance d'entrée de l'amplificateur (1/gm, où gm est la transconductance de l'amplificateur) soit très basse. Il faut également que l'impédance d'entrée (1/gm) de l'amplificateur (AMP) soit suffisamment faible pour que le produit de l'impédance (1/gm) avec la capacité (parasite) de l'entrée (C_{IN}) assure la bande passante désirée. En effet, on a un filtrage passe-bas de bande passante gm/C_{IN}. Plus la bande passante est large, plus le gm doit être élevé (et l'impédance d'entrée de l'amplificateur basse). Pour cette raison, il faut fournir beaucoup de courant à l'amplificateur pour augmenter sa transconductance (gm), donc réduire l'impédance d'entrée (1/gm), et augmenter la bande passante. La valeur maximale de RT dépend en premier lieu de la capacité de charge (CL) du noeud de sortie du fait que le produit de RT et CL va permettre de déterminer la fréquence de coupure et donc la bande passante de l'amplificateur. De plus, il faut que la valeur de l'impédance de l'entrée de l'amplificateur (1/gm) soit très basse par rapport à la valeur de la résistance de contre-réaction (RT) pour que le noeud d'entrée puisse être considéré comme une masse virtuelle. En d'autres termes, le produit gmxRT doit être beaucoup plus grand que 1 (gm×RT >> 1) ou la transconductance (gm) doit être très élevée pour une résistance donnée (RT). Pour une réalisation haute fréquence, CL et C_{IN} ne sont pas très différents (quelque centaines de fF), ce qui a pour effet d'augmenter encore la transconductance (gm) requise pour garantir gm×RT >> 1.

L'utilisation d'une inductance en contre-réaction de l'ampli (pour remplacer RT) est décrite mais n'offre pas d'avantage pour un système de télécommunications car le facteur de qualité provoque des résonances qui distordent le signal à détecter (ringing en anglais). On l'utilise néanmoins en parallèle à RT, ce qui limite le facteur de qualité Q de la contre-réaction pour améliorer un peu la bande passante de l'ampli (gain boosting).

En général, on utilise un amplificateur de type LNA (low noise amplifier) pour détecter un signal RF, lequel a une faible impédance d'entrée pour assurer la bande passante requise. Ceci a l'inconvénient de consommer beaucoup de courant. Dans la présente invention, on cherche, au contraire, à maximiser l'impédance d'entrée de l'amplificateur, qui par conséquent peut être d'une construction simple, réduisant ainsi le courant nécessaire pour détecter un signal à haute fréquence.

### BREVE DESCRIPTION DE L'INVENTION

La présente invention concerne un système de détection d'un signal (i_{PD}) ayant un contenu spectral étroit centré autour d'une fréquence centrale (ω_{C}), ledit système comprenant un photodétecteur (PD) polarisé par un élément polarisant et un amplificateur recevant le signal du photodétecteur pour amplifier le signal, **caractérisé en ce qu**'il comprend un composant comprenant au moins un premier élément inductif (L1) qui est connecté au photodétecteur, ledit composant et une capacité parasite (C_{IN}) parallèle au photodétecteur formant un circuit de résonance dont la fréquence de résonance correspond à la fréquence centrale

La présente invention donc permet de détecter un signal haute fréquence à bande étroite et de faible niveau toute en présentant une caractéristique de basse consommation de courant.

### DESCRIPTION SOMMAIRE DES DESSINS

La présente invention et ses avantages seront mieux compris en faisant référence aux figures annexes et à la description détaillée d'un ou plusieurs modes de réalisation particuliers, dans lesquelles :
- Figure 1 est un schéma d'un détecteur optoélectronique tel qu'il existe dans l'état de la technique
- Figure 2 montre un schéma équivalent d'un détecteur optoélectronique selon un mode de réalisation de la présente invention.
- Figure 3 montre un schéma équivalent d'un détecteur optoélectronique selon un autre mode de réalisation de la présente invention.

### DESCRIPTION DETAILLEE DE L'INVENTION

Selon la présente invention, il est proposé un système de détection d'un signal (i_{PD}) haute fréquence (ω_{C}) à bande étroite, ledit système ayant une basse consommation de courant. Le système comprend un générateur pour fournir le signal (i_{PD}) sous forme d'un courant, et un circuit de résonance parallèle pour faire varier l'impédance de la sortie du générateur en fonction de la fréquence du signal généré et pour convertir le courant en tension. Le système comprend en plus un étage d'amplification pour augmenter encore le gain en dégradant de façon minimale le bruit du système pour permettre la détection d'un signal de très faible amplitude. Selon l'invention, le générateur est un photodétecteur stimulé par de la radiation électromagnétique.

Selon un mode de réalisation de la présente invention, une simple inductance (L1) est comprise dans la réalisation du circuit de résonance parallèle et le photodétecteur est du type photodiode. La photodiode est polarisée au travers de l'inductance (L1) connectée à une source de tension. Ceci permet de maintenir la photodiode (PD) à une tension désirée en fournissant le courant nécessaire pour que la photodiode (PD) fonctionne correctement. Il est à noter que le signal à détecter a un contenu spectral centré autour d'une fréquence prédéterminée (ω_{C}) qui est de l'ordre de quelques gigahertz et très étroit (de l'ordre de 10⁻⁴×ω_{C}).

Le système selon ce mode de réalisation est illustré dans la Fig 2. Le signal à détecter (i_{PD}) apparaît sous la forme d'un courant sur un noeud (N) qui relie l'inductance (L1) à la photodiode (PD). Ce noeud (N) est couplé électriquement à l'entrée de l'amplificateur (MAMP) et le signal amplifié apparaît à la sortie de l'amplificateur (MAMP). Le noeud (N) ainsi configuré a donc une capacité parasite (C_{IN}). Cette capacité parasite (C_{IN}) forme avec l'inductance (L1) le circuit de résonance parallèle. La valeur de l'inductance est déterminée de sorte que sa réactance inductive à la fréquence du signal à détecter soit égale à la réactance capacitive de la capacité parasite (C_{IN}). En d'autres termes ω_{C}×L1=1/(ω_{C}×C_{IN}) Sous ces conditions, on a un filtre passe-bande avec un facteur de qualité (Q) et une largeur à mi-hauteur de 1/Q. Avec une inductance (L1) intégrée au circuit, on atteint un Q de 10 environ, alors que l'on obtient un Q de 50 environ avec une inductance (L1) externe au circuit. La résistance parallèle équivalente (Rp) a une valeur de ω×L×Q. La condition Rpxgm >> 1 dans la présente invention est analogue à la condition RT×gm >> 1 dans l'état de la technique, donc grâce à un facteur de qualité (Q) élevé on peut réaliser un gain important sans la consommation qui lui serait normalement associée. Sans la présente invention, on utiliserait un amplificateur transimpédance large bande avec 10GHz de bande passante à la place de celui qui est proposé. Typiquement, ce genre d'amplificateur consomme autour d'un watt, alors que l'amplificateur proposé par la présente invention consomme moins de deux milliwatts.

Puisque le noeud (N) a une impédance très élevée, il suffit d'utiliser un simple amplificateur de type MOS à source commune à faible bruit pour augmenter encore le gain en dégradant de façon minimale le bruit du système pour permettre la détection d'un signal de très faible amplitude. Dans un mode de réalisation de l'invention, l'amplificateur a une charge résistive sur la sortie. Dans un autre mode de réalisation, profitant du fait que le signal à détecter a un contenu spectral très réduit (une seule fréquence non-modulée), la charge à la sortie de l'amplificateur est assurée par une deuxième inductance (L2) dont la valeur est choisie pour maximiser le gain pour un signal à la fréquence prédéterminée (ω_{C}).

L'entrée de l'amplificateur peut être couplée en mode AC avec le noeud (N), i.e., avec une capacité de couplage (CC), et l'entrée de l'amplificateur peut donc être polarisée par une source de tension (Vb) à travers une résistance (Rb) de façon à ce que l'entrée de l'amplificateur soit à une tension optimale.

Dans la fabrication d'un circuit selon la présente invention, il se peut que la valeur de la capacité parasite (C_{IN}) ou la valeur de l'inductance (L1) varie d'un lot à l'autre ou d'une pièce à l'autre. Ceci aurait l'effet de déplacer la fréquence de résonance du circuit de résonance en dehors de la bande de fréquence adéquate pour détecter un signal à la fréquence prédéterminée. Pour cette raison, il est proposé d'agir sur la valeur de la capacité du noeud (N) en ajustant cette capacité. Ceci peut se faire de différentes manières, par exemple par l'emploi d'une capacité ajustable (trim capacitor) ou par l'emploi de plusieurs capacités que l'on peut connecter ou déconnecter au noeud N, par exemple par le dépôt ciblé de métal lors de la fabrication. Ceci peut être également accompli par un système de laser-trimming où le noeud (N) est connecté à une capacité dont la valeur est ajustée par ablation laser au moment du test de l'ensemble.

Selon un autre mode de réalisation de la présente invention, le circuit de résonance comprend un résonateur électromécanique de type résonateur à onde de volume ou Bulk Acoustic Wave (BAW), comme illustré dans la Fig 3. Le résonateur à onde de volume (BAW) permet un filtrage encore plus sélectif et il présente, à l'anti-résonance, une impédance réelle élevée tout en permettant de neutraliser la capacité parasite (C_{IN}) du noeud (N). Selon un mode de réalisation, le résonateur électromécanique permet d'atteindre un facteur de qualité supérieur à 300. Dans ce mode de réalisation, la photodiode est polarisée à l'aide d'un circuit adaptif dont l'étage de sortie est une source de courant (CCS) contrôlée de façon à garantir une tension de polarisation fixe sur la diode en basse fréquence.

La présente invention peut être déployée par exemple dans un oscillateur Raman. Dans un tel dispositif, un faisceau laser ayant une première fréquence interagit avec un gaz, stimulant ainsi, par une interaction lumière-atome, l'émission d'un faisceau par effet Raman ayant une deuxième fréquence. Le battement entre la première fréquence et la deuxième fréquence produit une troisième fréquence, la fréquence de battement. Dans le cas où le gaz comprend par exemple du Rubidium-85 et où le laser est de type semi-conducteur à cavité verticale et à émission de surface émettant un faisceau de lumière à une longueur d'onde se situant entre 780nm et 794nm, la fréquence de battement sera de l'ordre de 3GHz avec une bande passante autour d'une centaine de kHz. Cette fréquence de battement est en général de très bas niveau et a un contenu spectral très réduit (une seule fréquence, non modulée). La présente invention peut donc être déployée dans un oscillateur Raman pour détecter ces fréquences de battement.

## Revendications

1. Système de détection d'un signal (i_{PD}) ayant un contenu spectral étroit centré autour d'une fréquence centrale (ω_{C}), ledit système comprenant un photodétecteur (PD) polarisé par un élément polarisant et un amplificateur recevant le signal du photodétecteur pour amplifier le signal, **caractérisé en ce qu'il comprend** un composant comprenant au moins un premier élément inductif (L1) qui est connecté au photodétecteur, ledit composant et une capacité parasite (C_{IN}) parallèle au photodétecteur formant un circuit de résonance dont la fréquence de résonance correspond à la fréquence centrale.

2. Système selon la revendication 1, **caractérisé en ce que** ledit composant est une inductance (L1), connecté à une source de tension formant ledit élément polarisant.

3. Système selon la revendication 1, **caractérisé en ce que** ledit composant est un résonateur électromécanique comprenant ledit élément inductif (L1) et ledit élément polarisant est une source de courant (CCS).

4. Système selon une quelconque des revendications 1 à 3, **caractérisé en ce que** l'amplificateur est un transistor MOS configuré en source commune.

5. Système selon une quelconque des revendications 1 à 4, **caractérisé en ce que** l'amplificateur comprend une charge inductive (L2) à la sortie pour maximiser l'amplification à la fréquence centrale (ω_{C}).

6. Système selon une quelconque des revendications 1 à 5, **caractérisé en ce que** l'entrée de l'amplificateur est polarisé par une source de tension Vb à travers une résistance Rb.

7. Système selon une quelconque des revendications 1 à 3, **caractérisé en ce que** au moins une capacité de réglage (C_{TRIM}) peut être connectée pour modifier la valeur de la capacité parasite (C_{IN}) et ainsi permettre un réglage de la fréquence de résonance

8. Système selon une quelconque des revendications 1 à 7, **caractérisé en ce que** le photodétecteur (PD) est une photodiode.
